# EUROPEAN PATENT APPLICATION

(11) **EP 4 776 836 A1**
(43) Date of publication of application: **15.07.2026**
(21) Application number: 25217289.5
(22) Date of filing: 20.11.2025
(51) Int. Cl.: H10W 70/04, H10W 74/01, H10W 70/40

(54) **SEMICONDUCTOR DEVICE AND METHOD THEREFOR**

(30) Priority: 10.12.2024 US 202418975195
(71) Applicant: NXP B.V., 5656 AG Eindhoven (NL)
(72) Inventor: Xie, Yi Xiu, 5656AG Eindhoven (NL); Kuo, Wen-Jen, 5656AG Eindhoven (NL); Tzou, Kuei-Kang, 5656AG Eindhoven (NL)
(74) Representative: Colaiuda, Antonella

(57) **Abstract**

A method of manufacturing a semiconductor device is provided. The method includes affixing a plurality of semiconductor die on a first major side of a leadframe having a plurality of package sites, each semiconductor die affixed at a respective package site, the leadframe selectively plated such that un-plated regions are formed between the package sites. An encapsulant encapsulates the plurality of semiconductor die and the first major side of the leadframe. A second major side of the leadframe is exposed through the encapsulant. The un-plated regions are etched from the second major side of the leadframe to electrically isolate each package site from one another.

## Description

### Background

### Field

This disclosure relates generally to semiconductor device packaging, and more specifically, to a semiconductor device and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability, lower performance, and higher product or system costs. Accordingly, significant challenges exist in accommodating these features and applications while minimizing the impact on semiconductor devices' reliability, performance, and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified plan view, an example semiconductor device packaging array at a stage of manufacture in accordance with an embodiment.
FIG. 2 through FIG. 8 illustrate, in simplified cross-sectional views, a portion of the example semiconductor device packaging array at stages of manufacture in accordance with an embodiment.

### Detailed Description

Generally, there is provided, a packaged semiconductor device. A packaging array includes a selectively plated leadframe having an array of package sites surrounded by singulation lanes. The array of package sites are arranged in a grid of rows and columns. Each package site corresponds to a singulated individual semiconductor device unit after subsequent stages of manufacture, for example. Un-plated regions of the leadframe are formed coincident with the singulation lanes. The un-plated regions are configured and arranged to surround each individual package site of the packaging leadframe. A plurality of semiconductor die is mounted on the packaging leadframe such that each package site includes at least one semiconductor die. Each semiconductor die of the plurality of semiconductor die is interconnected with lead members of the packaging leadframe. An encapsulant is formed over the plurality of semiconductor die and the top side of the packaging leadframe. After encapsulation, the un-plated regions of the leadframe are etched to electrically isolate each package site from one another. Singulation cuts are formed through the encapsulant to singulate the package sites and form the individual semiconductor device units. By singulating the packaging array in this low-cost manner, metal burrs commonly associated with singulation sawing through leadframe metal is completely eliminated.

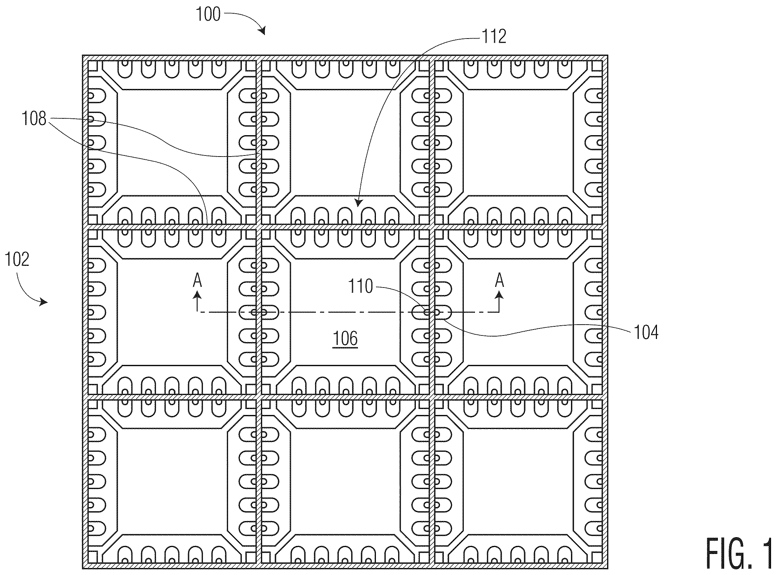

FIG. 1 illustrates, in a simplified bottom-side-up plan view, an example semiconductor device packaging array 100 at a stage of manufacture in accordance with an embodiment. At this stage, the packaging array 100 includes a package leadframe 102 having a plurality of package sites 112 surrounded by singulation lanes 108. The packaging leadframe 102 has a top major side and a bottom major side. The bottom major side of the package leadframe 102 is depicted in FIG. 1. The packaging leadframe 102 is configured and arranged for attachment and interconnection of a plurality of semiconductor die at a subsequent stage of manufacture, for example. In this embodiment, the package leadframe 102 is configured for a quad flat no-lead (QFN) type package. Alternatively, the package leadframe 102 may be configured for a flip-chip quad flat no-lead (FCQFN) type package. The number and arrangement of the package lead members 104 and die pad 106 in this embodiment are chosen for illustration purposes. In this embodiment, the packaging leadframe 102 is formed from a suitable metal material such as copper or copper alloys.

Each package site 112 of the packaging leadframe 102 includes a die pad 106 substantially surrounded by portions of lead members 104. For example, each lead member 104 is configured having a first portion proximate to a first die pad of a first package site and a second portion proximate to a second die pad of an adjacent second package site. The first portion and second portion of the lead member 104 are separated by a singulation lane 108, for example. The singulation lanes 108 may be characterized as regions between package sites 112 where the packaging array 100 is subsequently singulated into individual semiconductor device units, for example. Each lead member 104 includes a dimple 110 (e.g., recess, depression) formed at the bottom major side of the leadframe 102. In this embodiment, the leadframe 102 is selectively plated and includes un-plated regions arranged to substantially coincident with the singulation lanes 108.

Each package site 112, having an outer perimeter outline substantially defined by the singulation lanes 108, is representative of an of an individual semiconductor device unit (e.g., after subsequent stages of manufacture and singulation). In this embodiment, the package sites 112 of the packaging array 100 are arranged in an array of 3 rows by 3 columns. The packaging array 100 may be representative of a portion of a packaging panel or packaging strip having any number of package sites, for example. The predetermined singulation lanes 108 are orthogonally arranged and configured to substantially surround each package site 112 of the plurality. In this embodiment, 9 package sites 112 are depicted for illustration purposes.

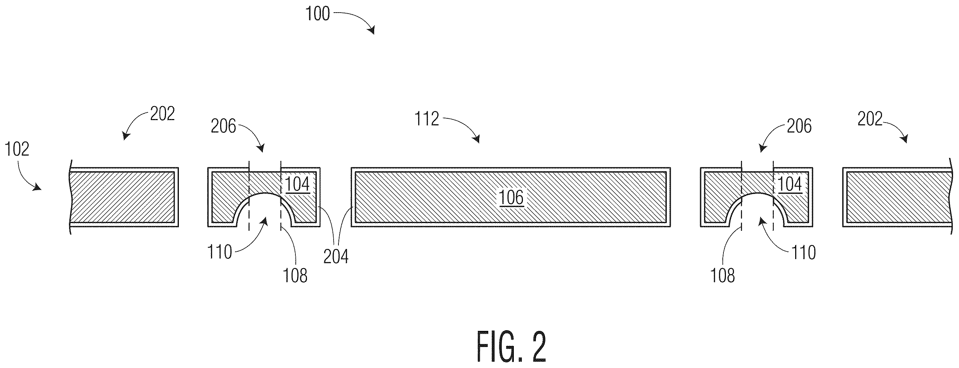

FIG. 2 through FIG. 8 illustrate, in simplified top-side-up cross-sectional views, a portion of the example semiconductor device packaging array 100 at stages of manufacture in accordance with an embodiment. Cross-sectional views of package site 112 and portions 208 of two adjacent package sites of the packaging array 100 taken along line A-A of FIG. 1 are shown at example stages of manufacture depicted in FIG. 2 through FIG. 8.

FIG. 2 illustrates, in a simplified cross-sectional view, the portion of the example semiconductor device packaging array 100 taken along line A-A of FIG. 1 at a stage of manufacture in accordance with an embodiment. At this stage, the packaging array 100 includes the selectively plated package leadframe 102 of FIG. 1 with the package site 112 separated from neighboring adjacent package site portions 202 by singulation lanes 108 (shown as dashed lines). In this embodiment, the package site 112 includes a die pad 106 flanked by lead members 104. Each lead member 104 includes the dimple 110 formed at the bottom major side of the leadframe 102. Accordingly, the region of the lead member 104 between the dimple 110 and the top major side has a reduced thickness. The dimple 110 may be formed by way of a stamping operation during manufacture of the leadframe 102, for example.

The leadframe 102 is selectively plated and includes plated regions 204 and predetermined un-plated regions 206. In this embodiment, the plated regions 204 are electroplated with a metal alloy material such as nickel-palladium-gold (NiPdAu) and the un-plated regions 206 are patterned to be substantially coincident with the singulation lanes 108 depicted on the lead members 104. The plated regions 204 are configured to enhance solder wettability serve as an etch block at subsequent stages of manufacture, for example. In this embodiment, the un-plated regions 206 are substantially centered in the dimples of lead members 104 and configured to form individual leads when etched at a subsequent stage of manufacture.

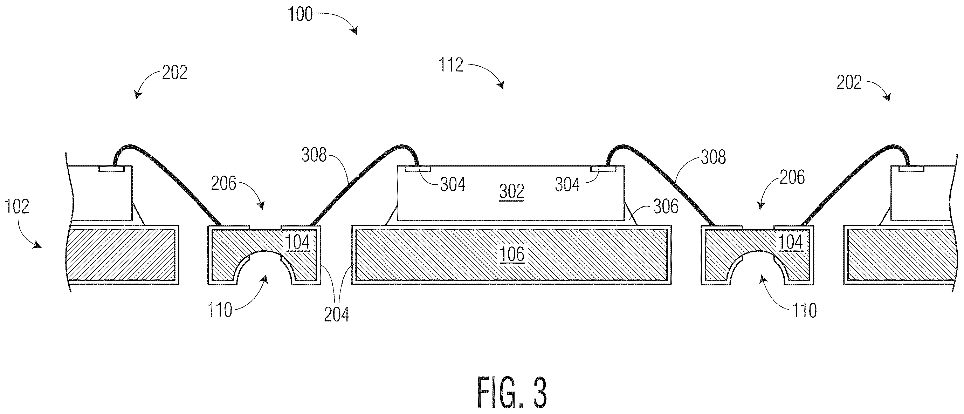

FIG. 3 illustrates, in a simplified cross-sectional view, the portion of the example semiconductor device packaging array 100 taken along line A-A of FIG. 1 at a subsequent stage of manufacture in accordance with an embodiment. At this stage, the packaging array 100 includes a plurality of semiconductor die (302) affixed at respective package sites (112) and interconnected to the leadframe 102. In this embodiment, each of the semiconductor die 302 is mounted on a respective die pad 106 of a unique package site 112 by way of a die attach material 306. The die attach material 306 may be in the form of a paste, film (e.g., die attach film, DAF), adhesive or other suitable die attach material. As depicted in FIG. 3, the semiconductor die 302 are mounted in the package site 112 and adjacent package site portions 202 at the first major side of the leadframe 102.

The semiconductor die 302 has an active side (e.g., major side having circuitry) and a backside (e.g., major side opposite of the active side). The semiconductor die 302 includes bond pads 304 interconnected with circuitry formed at the active side. In this embodiment, the semiconductor die 302 is configured in an active-side-up orientation with the backside attached to the die pad 106. The bonds pads 304 of the semiconductor die 302 are interconnected with portions of lead members 104 by way of bond wires 308, for example. Alternatively, the semiconductor die 302 may be configured in an active-side-down orientation with bond pads 304 interconnected with portions of lead members 104 by way of stud bumps, copper pillars, or the like, for example. The semiconductor die 302 may be formed from any suitable semiconductor material, such as silicon, germanium, gallium arsenide, gallium nitride and the like. The semiconductor die 302 may further include any digital circuits, analog circuits, RF circuits, memory, signal processor, MEMS, sensors, the like, and combinations thereof.

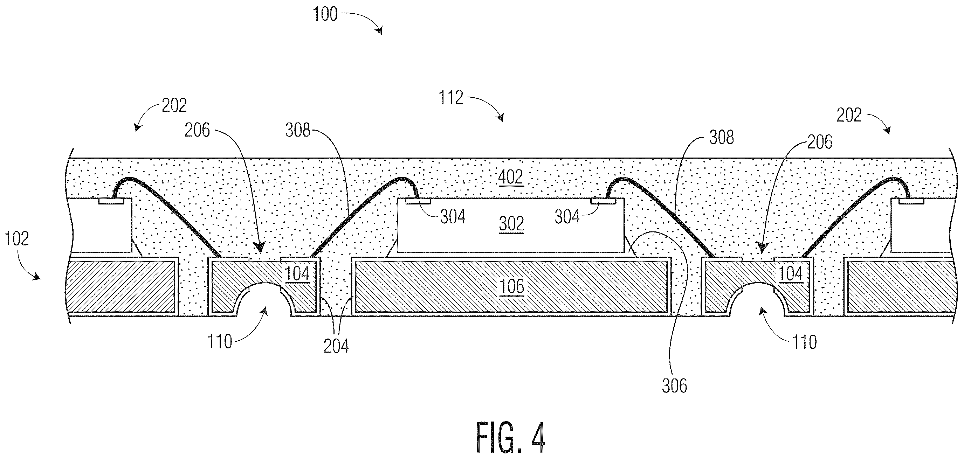

FIG. 4 illustrates, in a simplified cross-sectional view, the portion of the example semiconductor device packaging array 100 taken along line A-A of FIG. 1 at a subsequent stage of manufacture in accordance with an embodiment. At this stage, the packaging array 100 includes an encapsulant 402 (e.g., epoxy molding compound) formed over the plurality of semiconductor die 302 and the top major side of the packaging leadframe 102. In this embodiment, the top side of the packaging array 100 including the semiconductor die 302 mounted on the packaging leadframe 102 are over-molded with the encapsulant 302 during an encapsulation operation. The dimples 110 of the lead members 104 at the bottom major side of the leadframe 102 remain empty of the encapsulant 402.

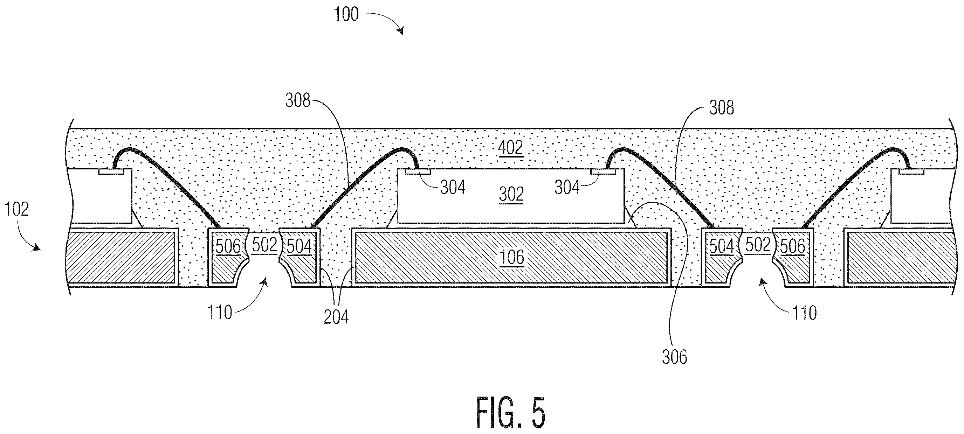

FIG. 5 illustrates, in a simplified cross-sectional view, the portion of the example semiconductor device packaging array 100 taken along line A-A of FIG. 1 at a subsequent stage of manufacture in accordance with an embodiment. At this stage, the packaging array 100 includes the lead members 104 (FIG. 4) etched to form individual leads 504 and 506. In this embodiment, the encapsulated array 100 is subjected to an etch operation whereby the un-plated portions of the lead members 104 are etched forming a void region 502 configured to bisect the lead members into individual, electrically isolated leads 504 and 506 (e.g., leads 504 not conductively connected with leads 506). For example, the leadframe 102 may be formed from a copper material and maybe selectively plated with a NiPdAu alloy such that the plated regions 204 are substantially unaffected by a chemical etch process. In this embodiment, the chemical etch process includes wet etchants such as hydrogen peroxide (H₂O₂) and phosphoric acid H₃PO₄) configured to remove leadframe material from the un-plated regions 206 (FIG. 4) in an isotropic manner. By etching the leadframe 102 in this manner, each package site (112) is electrically isolated from adjacent package sites. After the etch operation, a plurality of stepped flank leads (504, 506) are formed at a perimeter of each package site 112, for example.

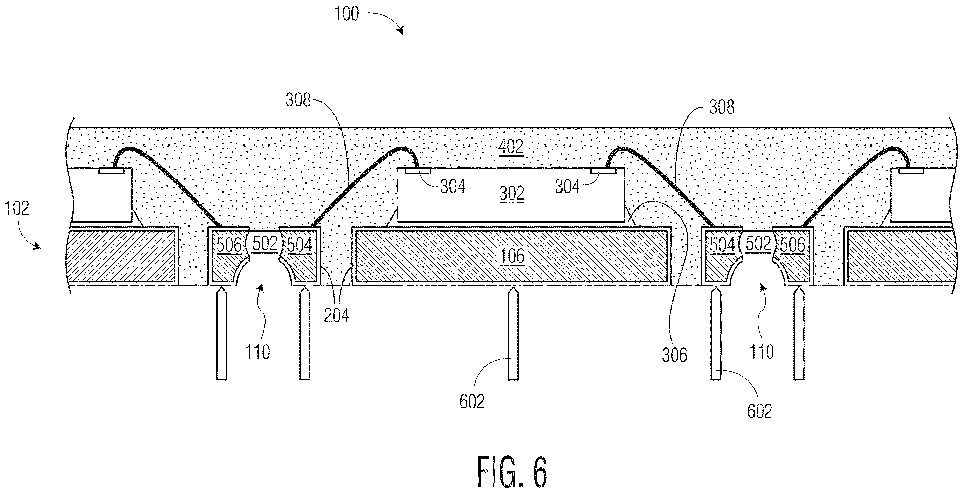

FIG. 6 illustrates, in a simplified cross-sectional view, the portion of the example semiconductor device packaging array 100 taken along line A-A of FIG. 1 at a subsequent stage of manufacture in accordance with an embodiment. At this stage, the encapsulated packaging array 100 with electrically isolated leadframe package sites are configured for functional testing. In this optional embodiment, probe needles 602 of a testing apparatus may contact conductive surfaces of leads 504 and 506 along with die pads 106 to perform functional testing and/or parametric testing of the semiconductor die 302 of each package site while in the packaging array 100 form (e.g., panel, strip). The testing apparatus may perform test operations of all package sites in parallel or may perform test operations sequentially on individual package sites, for example.

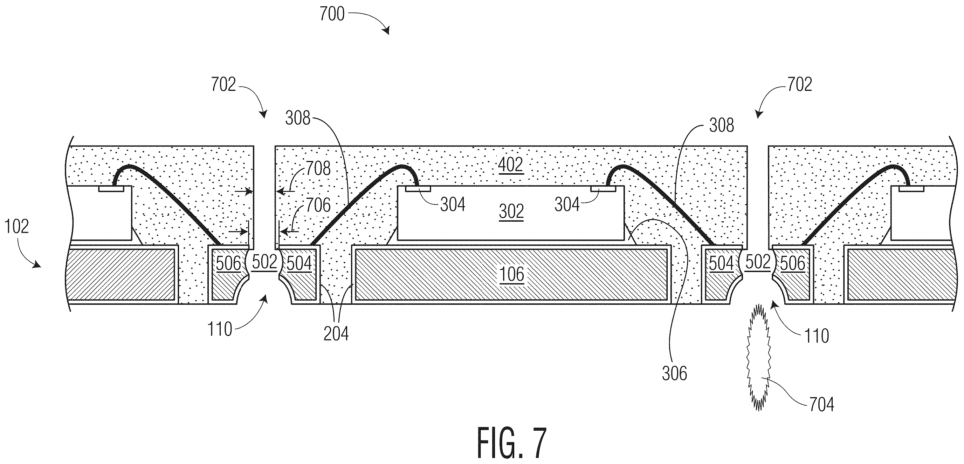

FIG. 7 illustrates, in a simplified cross-sectional view, the portion of the example semiconductor device packaging array taken along line A-A of FIG. 1 at a subsequent stage of manufacture in accordance with an embodiment. At this stage, the packaging array is completed and singulated into individual semiconductor device units 700. In this embodiment, a singulation cut 702 is formed along each singulation lane (108 of FIG. 1 and FIG. 2) to singulate the package sites (112 of FIG. 1) and form the individual semiconductor device units 700. In this embodiment, the singulation cuts are formed by way of a mechanical saw apparatus 704. The mechanical saw apparatus 704 performs the singulation cuts 702 through the encapsulant 402 and without contacting any portion of the leadframe 102. In this embodiment, the width dimension 708 of the singulation cuts is narrower than the width dimension 706 of the void region 502 separating leads 504 and 506. Accordingly, a portion of the encapsulant 402 overhangs an upper portion of the leads 504 and 506 after singulation into individual semiconductor device units 700. By singulating the packaging array in this manner, the potential formation of burrs commonly associated with singulation sawing through leadframe metal is completely eliminated.

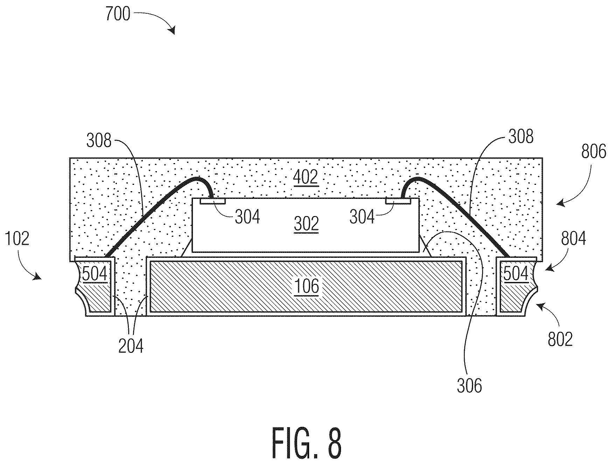

FIG. 8 illustrates, in a simplified cross-sectional view, the example semiconductor device unit 700 singulated from the portion of the example semiconductor device packaging array at a stage of manufacture in accordance with an embodiment. In this embodiment, the completed semiconductor device 700 includes the semiconductor die 302 wire bonded to leads 504 and encapsulated with the encapsulant 402. A stepped, wettable flank lead (504) is formed having a first step portion 802 adjacent to the second major side of the leadframe 102 and a second step portion 804 adjacent to the first major side of the leadframe. The stepped flank leads 504 include the first step portion 802 formed by way of the dimple 110 stamped into the leadframe 102 and the second step portion 804 formed by way of the selective etch which removed the un-plated portions (206) of the leadframe. In this embodiment, the first step portion 802 includes a curved plated surface and the second step portion 804 includes an un-plated curved surface which overhangs the first step portion 802. An outer sidewall 806 of the encapsulant 402 overhangs the second step portion 804 as depicted in FIG. 8.

Generally, there is provided, a method including A method of manufacturing a semiconductor device, the method comprising affixing a plurality of semiconductor die on a first major side of a leadframe having a plurality of package sites, each semiconductor die of the plurality of semiconductor die affixed at a respective package site of the plurality of package sites, the leadframe selectively plated such that un-plated regions are formed between the package sites; encapsulating with an encapsulant the first major side of the leadframe, each semiconductor die of the plurality of semiconductor die encapsulated by the encapsulant, a second major side of the leadframe exposed through the encapsulant; and etching the un-plated regions from the second major side of the leadframe to electrically isolate each package site from one another. The un-plated regions may be formed substantially coincident with singulation lanes of the leadframe. The method may further include forming singulation cuts along the singulation lanes of the leadframe to form individual semiconductor device units, a width of the singulation cuts is narrower than a width of the singulation lanes. The etching the un-plated regions may include wet etching such that leadframe material in the un-plated regions is removed in an isotropic manner. The method may further include interconnecting each semiconductor die of the plurality of semiconductor die to leads of respective package sites by way of bond wires. Each package site may include a die pad surrounded by a plurality of lead members, each lead member configured to span across adjacent package sites. The etching the un-plated regions of the leadframe may form a void region through each lead member of the leadframe such that the lead member is separated into separate isolated leads of the adjacent package sites. Each lead member may include a dimple formed in the second major side, the dimple including an un-plated region of the leadframe. The etching the un-plated regions may form a plurality of stepped flank leads at a perimeter of each package site.

In another embodiment, there is provided, a semiconductor device including a leadframe having a first major side and a second major side, the leadframe including a plurality of leads having a stepped flank, a first portion of the stepped flank plated and a second portion of the stepped flank un-plated; a semiconductor die mounted on the first major side of the leadframe and interconnected with the plurality of leads; and an encapsulant encapsulating the semiconductor die and the first major side of the leadframe, the second major side of the leadframe exposed through the encapsulant. The first portion of the stepped flank may be a portion of a dimple stamped into the leadframe. The first portion of the stepped flank may be adjacent to the second major side of the leadframe and the second portion of the stepped flank may be adjacent to the first major side of the leadframe. A sidewall of the encapsulant may overhang the second portion of the stepped flank. The semiconductor die may be interconnected with the plurality of leads by way of respective bond wires. The leadframe may be formed from a copper or copper alloy material.

In yet another embodiment, there is provided, a method of manufacturing a semiconductor device including affixing a plurality of semiconductor die on a first major side of a leadframe having a plurality of package sites, each semiconductor die affixed at a unique package site of the plurality of package sites, the leadframe selectively plated such that un-plated regions are formed on lead members between the package sites, the un-plated regions substantially coincident with singulation lanes of the leadframe; encapsulating with an encapsulant the first major side of the leadframe, each semiconductor die of the plurality of semiconductor die encapsulated by the encapsulant, a second major side of the leadframe exposed through the encapsulant; and etching the un-plated regions from the second major side of the leadframe to electrically isolate each package site from one another. The method may further include forming singulation cuts through the encapsulant along the singulation lanes to form individual semiconductor device units, a width of the singulation cuts is narrower than a width of the singulation lanes. Each lead member may include a dimple formed in the second major side, a portion of the dimple including one of the un-plated regions. The etching the un-plated regions may form a plurality of stepped flank leads at a perimeter of each package site. After etching the un-plated regions, each encapsulated semiconductor die may be configured for functional testing by way of the exposed second major side of the leadframe.

By now, it should be appreciated that there has been provided, a packaged semiconductor device. A packaging array includes a selectively plated leadframe having an array of package sites surrounded by singulation lanes. The array of package sites are arranged in a grid of rows and columns. Each package site corresponds to a singulated individual semiconductor device unit after subsequent stages of manufacture, for example. Un-plated regions of the leadframe are formed coincident with the singulation lanes. The un-plated regions are configured and arranged to surround each individual package site of the packaging leadframe. A plurality of semiconductor die is mounted on the packaging leadframe such that each package site includes at least one semiconductor die. Each semiconductor die of the plurality of semiconductor die is interconnected with lead members of the packaging leadframe. An encapsulant is formed over the plurality of semiconductor die and the top side of the packaging leadframe. After encapsulation, the un-plated regions of the leadframe are etched to electrically isolate each package site from one another. Singulation cuts are formed through the encapsulant to singulate the package sites and form the individual semiconductor device units. By singulating the packaging array in this low-cost manner, metal burrs commonly associated with singulation sawing through leadframe metal is completely eliminated.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method of manufacturing a semiconductor device, the method comprising:
affixing a plurality of semiconductor die on a first major side of a leadframe having a plurality of package sites, each semiconductor die of the plurality of semiconductor die affixed at a respective package site of the plurality of package sites, the leadframe selectively plated such that un-plated regions are formed between the package sites;
encapsulating with an encapsulant the first major side of the leadframe, each semiconductor die of the plurality of semiconductor die encapsulated by the encapsulant, a second major side of the leadframe exposed through the encapsulant; and
etching the un-plated regions from the second major side of the leadframe to electrically isolate each package site from one another.

2. The method of claim 1, wherein the un-plated regions is formed substantially coincident with singulation lanes of the leadframe.

3. The method of claim 2, further comprising forming singulation cuts along the singulation lanes of the leadframe to form individual semiconductor device units, a width of the singulation cuts is narrower than a width of the singulation lanes.

4. The method according to any preceding claim, wherein etching the un-plated regions includes wet etching such that leadframe material in the un-plated regions is removed in an isotropic manner.

5. The method according to any preceding claim, further comprising interconnecting each semiconductor die of the plurality of semiconductor die to leads of respective package sites by way of bond wires.

6. The method according to any preceding claim, wherein each package site includes a die pad surrounded by a plurality of lead members, each lead member configured to span across adjacent package sites.

7. The method of claim 6, wherein etching the un-plated regions of the leadframe forms a void region through each lead member of the leadframe such that the lead member is separated into separate isolated leads of the adjacent package sites.

8. The method of claim 6 or claim 7, wherein each lead member includes a dimple formed in the second major side, the dimple including an un-plated region of the leadframe.

9. The method of claim 6, wherein etching the un-plated regions forms a plurality of stepped flank leads at a perimeter of each package site.

10. A semiconductor device comprising:
a leadframe having a first major side and a second major side, the leadframe including a plurality of leads having a stepped flank, a first portion of the stepped flank plated and a second portion of the stepped flank un-plated;
a semiconductor die mounted on the first major side of the leadframe and interconnected with the plurality of leads; and
an encapsulant encapsulating the semiconductor die and the first major side of the leadframe, the second major side of the leadframe exposed through the encapsulant.

11. The semiconductor device of claim 10, wherein the first portion of the stepped flank is a portion of a dimple stamped into the leadframe.

12. The semiconductor device of claim 10, wherein the first portion of the stepped flank is adjacent to the second major side of the leadframe and the second portion of the stepped flank is adjacent to the first major side of the leadframe.

13. The semiconductor device of any of claim 10 to 12, wherein a sidewall of the encapsulant overhangs the second portion of the stepped flank.

14. The semiconductor device of any of claim 10 to 13, wherein the semiconductor die is interconnected with the plurality of leads by way of respective bond wires.

15. The semiconductor device of any of claim 10 to 14, wherein the leadframe is formed from a copper or copper alloy material.
